# DEMANDE DE BREVET EUROPEEN

(11) **EP 0 843 349 A1**
(43) Date de publication de la demande: **20.05.1998**
(21) Numéro de dépôt: 97410129.7
(22) Date de dépôt: 18.11.1997
(51) Int. Cl.: H01L 21/331, H01L 29/732

(54) **Procédé de fabrication d'un transistor NPN de surface minimale**

(30) Priorité: 19.11.1996 FR 9614408
(71) Demandeur: SGS-THOMSON MICROELECTRONICS S.A., 94250 Gentilly (FR)
(72) Inventeur: Gris, Yvon, 38210 Tullins (FR)
(74) Mandataire: de Beaumont, Michel

(57) **Abrégé**

L'invention concerne un transistor NPN dont la base et l'émetteur sont formés à l'intérieur d'une fenêtre définie dans un oxyde épais selon un premier masque (200) sensiblement rectangulaire. Une partie au moins de la zone définie par le premier masque est recouverte d'une couche de silicium polycristallin (123), de préférence le long d'un côté de ce premier masque, une zone de contact de base (132) étant formée sous cette zone de silicium polycristallin, les trois autres côtés de la zone d'émetteur-base étant délimités par une couche de protection (121-122), une zone de base intrinsèque (133) étant formée dans l'ouverture ainsi définie puis une zone d'émetteur (149) recouverte d'une couche de silicium polycristallin dopé de type N (146).

## Description

La présente invention concerne le domaine des circuits intégrés et plus particulièrement la fabrication d'un transistor NPN.

Dans une demande de brevet déposée le même jour par la demanderesse (N° de référence du mandataire B3221), il est décrit un procédé de fabrication d'un transistor bipolaire compatible avec une technologie BICMOS (c'est-à-dire une technologie permettant la fabrication simultanée de transistors bipolaires et de transistors MOS complémentaires).

Un exemple d'un transistor NPN obtenu en utilisant une technologie BICMOS est représenté dans la figure 12A de la demande de brevet susmentionnée, qui est reproduite dans la figure 1 ci-jointe.

Ce transistor NPN est formé dans une couche épitaxiée 2 surmontant une couche enterrée 3 formée dans un substrat de silicium de type P (non représenté). Le transistor est formé dans une fenêtre ménagée dans une couche d'oxyde épais 5. Les références 21 et 22 désignent des couches minces d'oxyde de silicium et de nitrure de silicium qui sont utilisées pour protéger d'autres éléments du circuit intégré (tels que des transistors CMOS) pendant la fabrication du transistor bipolaire. La référence 23 désigne une portion d'une couche de silicium polycristallin dopé de type P dite silicium polycristallin de base puisque c'est à partir de cette couche de silicium qu'est formée la diffusion de contact de base 32. La couche de silicium polycristallin 23 est revêtue d'une couche d'oxyde de silicium d'encapsulation 24. Une ouverture centrale d'émetteur-base est formée dans l'ensemble des couches 23 et 24. Une couche mince d'oxyde de silicium 31 recouvre les flancs de la couche de silicium polycristallin 23 et le fond de l'ouverture. Dans cette ouverture est réalisée une implantation à haute énergie de type N destinée à la formation d'une région de sous-collecteur de niveau choisi de dopage. Les parois de l'ouverture d'émetteur-base sont revêtues d'une couche de nitrure de silicium 44. Des espaceurs latéraux en silicium polycristallin 43 sont formés sur les flancs de l'ouverture. Avant formation de la région de nitrure de silicium 44 et des espaceurs de silicium polycristallin 43 est formée une implantation de base intrinsèque 33. Après formation des espaceurs, on dépose une couche 46 de silicium polycristallin fortement dopé de type N à partir de laquelle est formée la région d'émetteur 49. La couche de silicium polycristallin 46 est revêtue d'une couche d'oxyde d'encapsulation 47. L'ensemble de la structure est revêtu d'une couche d'isolement et de planarisation 51 à travers laquelle sont formées des ouvertures de contact d'émetteur 55 rejoignant la couche de silicium polycristallin 46 et de contact de base 56 rejoignant la couche de silicium polycristallin 23. En outre, un contact de collecteur (non représenté) est pris par l'intermédiaire d'une diffusion profonde de type N vers la couche enterrée 3.

Ce transistor est à symétrie circulaire, l'émetteur étant central et le silicium polycristallin de base étant en anneau autour de cet émetteur.

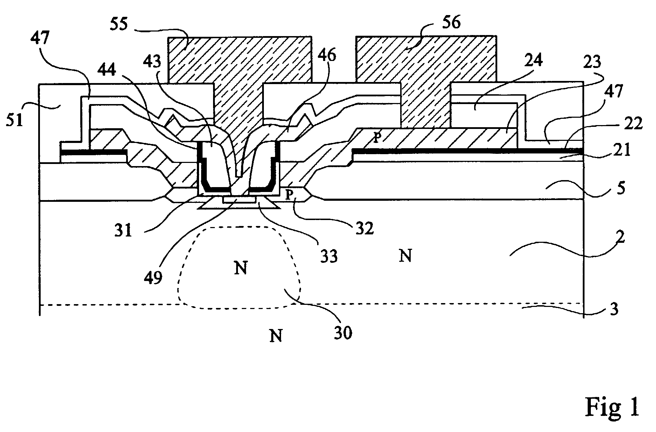

Un objet de la présente invention est de prévoir un transistor NPN du même type général de celui de la figure 1 mais dont la topologie est modifiée pour qu'il puisse avoir une dimension minimale.

Un autre objet de la présente invention est de prévoir un transistor NPN dont les capacités parasites sont réduites et qui soit donc susceptible de fonctionner à des fréquences élevées.

Pour atteindre ces objets, la présente invention prévoit un transistor NPN dont la base et l'émetteur sont formés à l'intérieur d'une fenêtre définie dans un oxyde épais selon un premier masque sensiblement rectangulaire. Une partie au moins de la zone définie par le premier masque est recouverte d'une couche de silicium polycristallin, de préférence le long d'un côté de ce premier masque ; une zone de contact de base est formée sous cette zone de silicium polycristallin ; les trois autres côtés de la zone d'émetteur-base sont délimités par une couche de protection, une zone de base intrinsèque étant formée dans l'ouverture ainsi définie puis une zone d'émetteur recouverte d'une couche de silicium polycristallin dopé de type N.

La présente invention prévoit aussi un procédé de fabrication d'un transistor NPN dans une couche épitaxiée de type N comprenant les étapes consistant à délimiter une fenêtre dans une couche d'oxyde épais, selon un premier masque sensiblement rectangulaire ; déposer une couche de protection et l'éliminer à l'intérieur d'une ouverture définie par un deuxième masque de façon générale interne au premier masque et débordant d'un côté de celui-ci ; déposer une première couche de silicium polycristallin et une couche d'oxyde de silicium et l'ouvrir à l'intérieur d'un contour défini par un troisième masque englobant une partie commune des deux premiers masques ; procéder à un recuit thermique oxydant ; procéder à une implantation de type P de formation de la base intrinsèque ; déposer une couche de nitrure de silicium et une deuxième couche de silicium polycristallin, graver la couche de silicium polycristallin de façon anisotrope pour laisser en place seulement des espaceurs le long des flancs de l'ouverture définie par le troisième masque, et éliminer la couche de nitrure de silicium là où elle n'est pas protégée par les espaceurs ; procéder à une implantation de type N à forte énergie pour former une région de collecteur ; et déposer une couche de silicium polycristallin d'émetteur de type N.

Selon un mode de réalisation de la présente invention, la couche de protection comprend une couche d'oxyde de silicium et une couche de nitrure de silicium.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
la figure 1 représente un transistor NPN fabriqué par un procédé décrit dans une demande de brevet déposée le même jour que la présente demande ;
les figures 2A, 2B, 2C représentent respectivement une vue de dessus de masque, et des vues en coupe schématiques prises selon les lignes B-B et C-C de la figure 2A, d'un exemple de composant selon la présente invention à un stade intermédiaire de fabrication ; et
les figures 3A, 3B, 3C représentent respectivement une vue de dessus de masque, et des vues en coupe schématiques prises selon les lignes B-B et C-C de la figure 3A, d'un exemple de composant selon la présente invention à un stade ultérieur de fabrication.

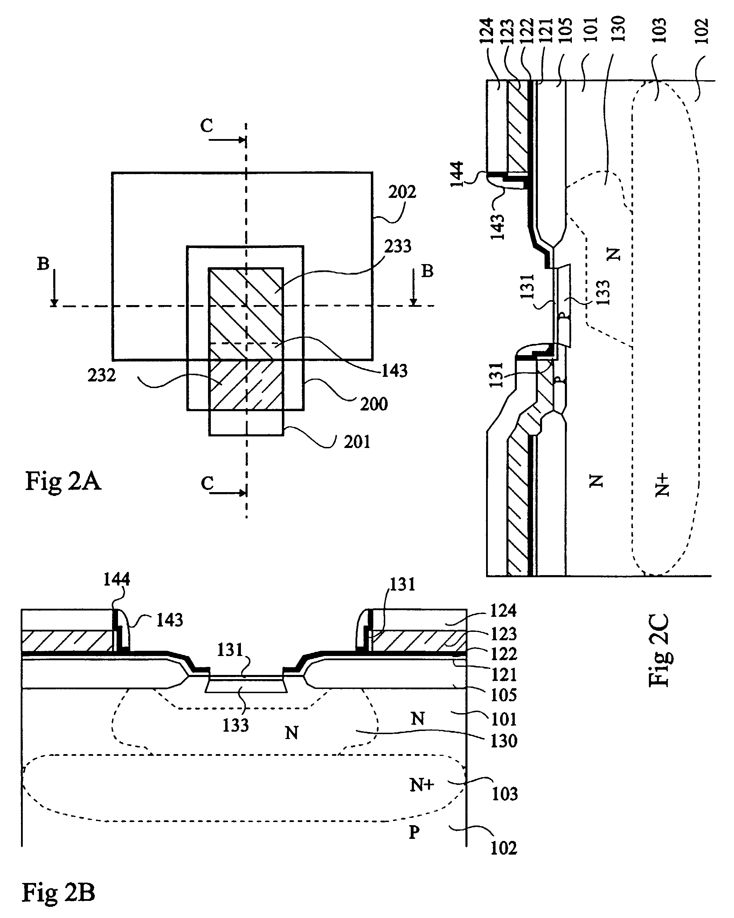

Les figures 2A à 2C représentent un transistor NPN selon la présente invention à un stade intermédiaire de fabrication. Les étapes technologiques sont sensiblement les mêmes que celles décrites en relation avec la figure 1 mais la topologie et les positions relatives des masques sont distinctes.

Le transistor NPN est formé dans une couche épitaxiée 101 de type N formée sur un substrat de type P 102, une couche enterrée fortement dopée de type N (N⁺) 103 étant disposée sous les parties actives du transistor NPN. L'isolation latérale des transistors NPN entre eux et par rapport à d'autres éléments du circuit intégré se fait par des murs d'isolement constitués de diffusions de type P s'étendant sur toute l'épaisseur de la couche épitaxiée 101. La structure d'émetteur-base est formée à l'intérieur d'une fenêtre délimitée par un masque de forme sensiblement rectangulaire 200 dans une couche d'oxyde épais 105.

Une couche de protection 121-122, par exemple constituée d'une couche d'oxyde de silicium 121 et d'une couche de nitrure de silicium 122, est déposée sur la structure. Cette couche de protection est ouverte selon le contour d'un masque 201 également de forme sensiblement rectangulaire. Comme le représente la figure 2A, le masque 201 est disposé à l'intérieur de trois côtés du masque 200 et déborde par rapport à ce masque 200 sur le quatrième côté.

Ensuite sont successivement déposées une couche de silicium polycristallin "de base" 123, dopé de type P par implantation après dépôt, et une couche d'oxyde de silicium d'encapsulation 124. Une ouverture est formée dans les couches 123-124 selon le contour d'un masque de forme sensiblement rectangulaire 202 dont trois côtés sont extérieurs aux contours des masques 200 et 201 et dont le quatrième côté coupe ces masques 200 et 201. La partie du masque 202 en débordement par rapport au masque 200 est opposée à la partie du masque 201 débordant de ce masque 200. Ainsi, après gravure, la couche de silicium polycristallin dopé de type P 123 est en contact avec la surface supérieure de la couche épitaxiée 101 dans une portion qui correspond à la zone hachurée 232 de la figure 2A. On procède ensuite à une oxydation thermique pour oxyder les flancs apparents de la couche 122 et le fond de l'ouverture sur la couche épitaxiée 101. La portion restante de cette couche d'oxyde thermique après des traitements ultérieurs est désignée dans les figures 2B et 2C par la référence 131. Pendant cette étape, le dopant de type P contenu dans le silicium polycristallin 123 diffuse dans la couche épitaxiée 101 pour former une région de contact de base 132 dont le contour correspond sensiblement à la zone 232 susmentionnée.

L'étape suivante consiste en une implantation d'un dopant de type P destinée à la formation de la région de base intrinsèque 133. Cette base intrinsèque est de préférence implantée au bore à faible énergie (par exemple 10¹³ atomes/cm² sous 5 keV). Avec ce niveau d'implantation, les dopants ne peuvent traverser ni la couche de protection 121-122 ni a fortiori l'ensemble de la couche de silicium polycristallin 123 et de la couche d'oxyde de silicium 124. L'implantation est donc limitée à une "ouverture de base intrinsèque" 233 définie par l'intersection des masques 200 et 202. De préférence, cette implantation est réalisée sous une incidence oblique (par exemple sous un angle de 7°) pour faire pénétrer le dopant au-delà du contour de l'ouverture.

On procède alors au dépôt d'une couche de nitrure de silicium et d'une couche de silicium polycristallin. La couche de silicium polycristallin est gravée sur toute son épaisseur de façon anisotrope pour laisser en place seulement des espaceurs 143 sur les flancs des ouvertures formées dans les couches 123 et 124. On grave ensuite toute la surface apparente de la couche de nitrure de silicium qui vient d'être déposée de sorte que cette couche de nitrure de silicium reste en place seulement dans des portions 144 enfermées par les espaceurs 143.

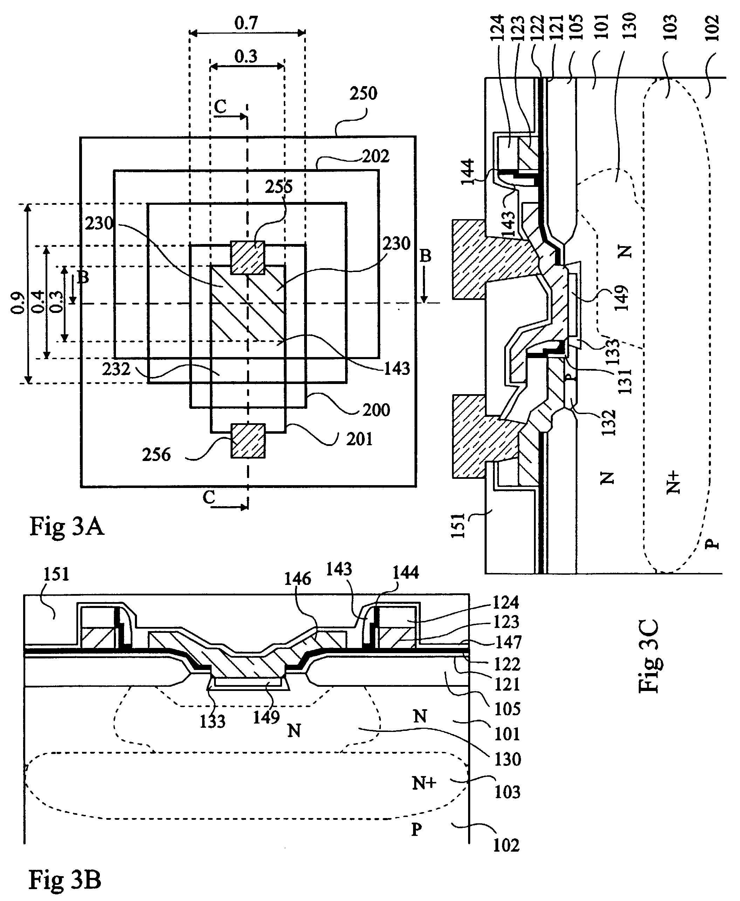

Par les étapes ci-dessus, on a défini une ouverture, dite "ouverture d'émetteur", dont le contour est désigné par la référence 230 dans la vue de dessus de la figure 3A. Cette ouverture est recouverte seulement de la couche mince d'oxyde de silicium 131 comme on le voit en figures 2B et 2C. La surface de cette ouverture est définie par l'intersection des masques 200 et 202 (ouverture de base intrinsèque), réduite du côté du bord du masque 202 de la largeur de l'espaceur 143.

On procède alors à une implantation d'un dopant de type N destinée à définir le collecteur 130 du transistor NPN. Cette implantation est réalisée à dose moyenne et à forte énergie (par exemple 10¹² à 10¹⁴ atomes/cm² sous 500 keV). Le résultat de cette implantation apparaît en figures 2B et 2C. On notera que, en raison de la topologie des diverses couches gravées précédemment, cette implantation s'étend sous l'ouverture d'émetteur 230, et au-delà de cette ouverture mais pas sous la région de contact de base 223 qui est masquée par l'ensemble des couches 123 et 124 et l'espaceur 143. On obtient ainsi une région effective de collecteur 130 d'étendue latérale limitée, sensiblement égale à celle de la base intrinsèque. Ceci contribue à l'obtention d'un transistor NPN de faible capacité parasite entre collecteur et base extrinsèque. L'implantation est optimisée (par exemple, par implantations successives) pour que le profil du collecteur fournisse le meilleur compromis possible entre, d'une part, la résistance de collecteur et le temps de transit dans ce collecteur et, d'autre part, l'obtention de tensions de claquage suffisamment élevées émetteur-collecteur (typiquement 4 volts) et base-collecteur et d'une faible capacité base-collecteur. On notera aussi que cette implantation de collecteur permet de choisir au préalable une couche épitaxiée 2 de dopage et d'épaisseur propres à optimiser des transistors CMOS formés sur la même puce et d'optimiser ensuite indépendamment les caractéristiques du transistor NPN. Notamment, la couche épitaxiée 101 pourra être plus épaisse que si elle devait servir directement de couche de collecteur du transistor NPN.

Comme le représentent les figures 3A à 3C, on procède alors au dépôt d'une couche de silicium polycristallin dopé de type N 146 qui est maintenue en place selon le contour d'un masque 246 qui assure que cette couche est présente au moins au-dessus de l'ouverture d'émetteur 230 et déborde de celle-ci pour permettre de prendre ultérieurement des contacts. C'est à partir des dopants contenus dans la couche de silicium polycristallin dopé de type N 146 qu'est formée une région d'émetteur 149.

Après la formation et la découpe de la couche de silicium polycristallin 146, on délimite l'ensemble des couches 123 et 124 assez largement au-dessus de la zone d'oxyde épais par un masque 250 dont le contour enveloppe ceux de tous les masques précédemment mentionnés.

On procède alors au dépôt d'une couche d'un produit isolant de planarisation 151 et l'on forme des ouvertures dans cette couche et les couches sous-jacentes, conformément à des masques de contact 255 et 256 pour former des contacts d'émetteur 155 et de base 156, respectivement en contact avec la couche de silicium polycristallin 146 et avec la couche de silicium polycristallin 123.

Bien que cela ne soit pas représenté dans les figures, il est clair que la couche enterrée 3 sera prolongée d'un côté ou de l'autre de la structure pour venir en contact avec un caisson de type N permettant une reprise de contact de collecteur, comme cela est usuel.

L'utilisation de cette technique et de cette topologie permet d'obtenir un transistor NPN de dimension minimale. En effet, dans une filière de fabrication dans laquelle la dimension minimale d'une ouverture dans un masque est de 0,3 µm, on pourra choisir pour le masque 200 des dimensions de 0,7 x 0,9 µm, et pour le masque 201 une largeur (dans le sens où le masque 200 a une dimension de 0,7 µm) de 0,3 µm. Ainsi, la zone hachurée désignée par la référence 230 de contact effectif d'émetteur peut présenter des dimensions de l'ordre de 0,3 x 0,3 µm, c'est-à-dire que l'ouverture efficace d'émetteur a une surface de l'ordre de 0,1 µm².

On notera que le masque d'émetteur 230 est confondu sur trois côtés avec le masque de base intrinsèque 233. Il faut donc que la diffusion de base soit plus étendue sous le masque que la diffusion d'émetteur. Cela se produit pour plusieurs raisons :
- la base est de préférence implantée sous incidence oblique ;
- le bore diffuse latéralement plus que l'arsenic ;
- la base résulte d'une implantation suivie d'un recuit de diffusion dans un four tandis que l'émetteur résulte d'une diffusion solide-solide due à un recuit thermique rapide.

En plus du fait qu'il occupe une surface de silicium particulièrement petite, le transistor selon l'invention présente de nombreux avantages.

Dans une structure de dessin classique, à base annulaire et émetteur central, et de dimensions critiques, la surface de l'émetteur ou surface utile (zone de contact entre le silicium polycristallin et le silicium monocristallin) est de l'ordre de 0,2 µm² et la surface active (surface de l'ouverture dans l'oxyde épais) est de 2 µm². Ainsi le rapport (surface utile)/(surface active) est de l'ordre de 0,2/2 = 0,1. Avec la topologie proposée, on a respectivement 0,1 µm² pour la surface d'émetteur et 0,2 µm² pour la surface active. Le rapport (surface utile)/(surface active) devient 0,1/0,2 = 0,5. La topologie proposée est donc beaucoup plus efficace.

D'autre part, la surface utile passe de 0,2 à 0,1 µm². La surface du transistor intrinsèque est donc diminuée d'un facteur 2. Il en résulte que le transistor aura une même fréquence de transition pour un courant 2 fois plus faible et donc une consommation réduite.

Enfin les parties parasites du transistor passent de 1,7 à 0,1 µ². En particulier, la capacité extrinsèque base-collecteur sera réduite d'autant.

## Revendications

1. Transistor NPN dont la base et l'émetteur sont formés à l'intérieur d'une fenêtre définie dans un oxyde épais selon un premier masque (200) sensiblement rectangulaire, caractérisé en ce qu'une partie au moins de la zone définie par le premier masque est recouverte d'une couche de silicium polycristallin (123), de préférence le long d'un côté de ce premier masque, une zone de contact de base (132) étant formée sous cette zone de silicium polycristallin, les trois autres côtés de la zone d'émetteur-base étant délimités par une couche de protection (121-122), une zone de base intrinsèque (133) étant formée dans l'ouverture ainsi définie puis une zone d'émetteur (149) recouverte d'une couche de silicium polycristallin dopé de type N (146).

2. Procédé de fabrication d'un transistor NPN dans une couche épitaxiée de type N (101) comprenant les étapes suivantes :
délimiter une fenêtre dans une couche d'oxyde épais, selon un premier masque sensiblement rectangulaire (200),
déposer une couche de protection (121-122) et l'éliminer à l'intérieur d'une ouverture définie par un deuxième masque (201) de façon générale interne au premier masque et débordant d'un côté de celui-ci,
déposer une première couche de silicium polycristallin (123) et une couche d'oxyde de silicium (124) et l'ouvrir à l'intérieur d'un contour défini par un troisième masque (202) englobant une partie commune des deux premiers masques,
procéder à un recuit thermique oxydant,
procéder à une implantation de type P de formation de la base intrinsèque,
déposer une couche de nitrure de silicium et une deuxième couche de silicium polycristallin, graver la couche de silicium polycristallin de façon anisotrope pour laisser en place seulement des espaceurs (143) le long des flancs de l'ouverture définie par le troisième masque, et éliminer la couche de nitrure de silicium (144) là où elle n'est pas protégée par les espaceurs,
procéder à une implantation de type N à forte énergie pour former une région de collecteur (130), et
déposer une couche de silicium polycristallin d'émetteur de type N (146).

3. Procédé selon la revendication 2, caractérisé en ce que la couche de protection comprend une couche d'oxyde de silicium (121) et une couche de nitrure de silicium (122).
